# EUROPEAN PATENT APPLICATION

(11) **EP 2 566 039 A1**
(43) Date of publication of application: **06.03.2013**
(21) Application number: 11775096.8
(22) Date of filing: 28.04.2011
(51) Int. Cl.: H02N 2/00

(54) **VIBRATION POWER GENERATION DEVICE**

(30) Priority: 28.04.2010 JP 2010104227
(71) Applicant: Panasonic Corporation, Kadoma-shi Osaka 571-8501 (JP)
(72) Inventor: OGAWA, Junya, Osaka 540-6207 (JP); YAMAUCHI, Norihiro, Osaka 540-6207 (JP); MATSUSHIMA, Tomoaki, Osaka 540-6207 (JP); AIZAWA, Koichi, Osaka 540-6207 (JP)
(74) Representative: Appelt, Christian W.
(86) International application number: PCT/JP2011/060351
(87) International publication number: WO 2011/136315

(57) **Abstract**

A vibration power generation device comprising: a frame section; a weight section, a flexure section; and a power generation section. The weight section is provided inside the frame section. The flexure section is joined between the frame section and the weight section, and is configured to bend in response to a vibration of the weight section. The power generation section is composed of a laminate on one surface of the flexure section. The laminate has a lower electrode, a piezoelectric layer and an upper electrode which are laminated in this order from the abovementioned one surface. The power generation section is configured to generate an alternating-current voltage in response to an oscillation of the weight section. A resonance frequency adjustment means is provided between the frame section and the weight section.

## Description

### TECHNICAL FIELD

The present invention relates to a vibration power generation device, obtained by the MEMS (micro electro mechanical systems) technology, for converting a vibration energy into an electric energy.

### BACKGROUND ART

There has been known a power generating device as a kind of MEMS device configured to convert a vibration energy, derived from vibration such as movement of a car or a human, into an electric energy. Such power generating devices have been studied (refer to Patent Literature 1).

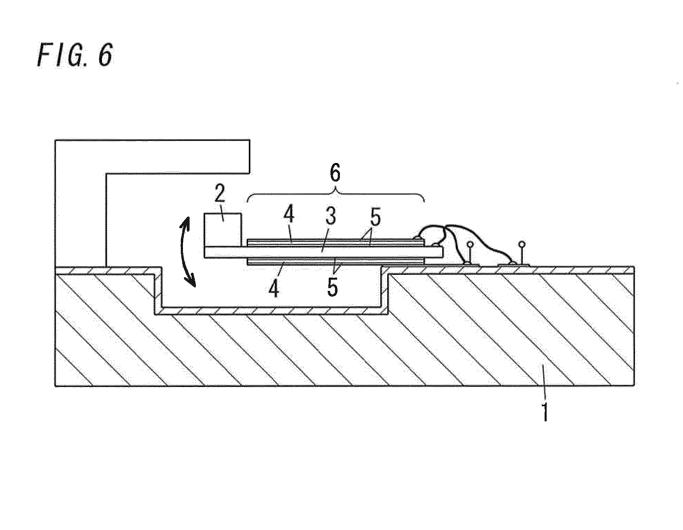

As a power generating device, Patent Literature 1 discloses a piezoelectric power generating device includes: a substrate **1;** a weight section **2** provided on the substrate **1;** a phosphor copper bronze sheet **3** which is joined between the substrate **1** and the weight section **2,** and is configured to bend in response to a displacement of the weight section **2;** and a piezoelectric power generation section **6** which is composed of laminates, each of which being composed of a piezoelectric ceramic plate **4** and electrodes **5,** provided on respective surfaces of the phosphor copper bronze sheet **3,** and which is configured to generate an alternating-current voltage in response to an oscillation of the weight section **2,** as is shown in Fig. 6.

### CITATION LIST

### PATENT LITERATURE

PATENT LETERATURE 1: JAPANESE PATENT APPLICATION PUBLICATION No.H7-107752A.

### SUMMARY OF INVENTION

### TECHNICAL PROBLEM

However, when considering of applying to an apparatus, the conventional piezoelectric power generating device has a problem that the resonance frequency thereof is not designed in accordance with the frequency of environmental vibration of the apparatus.

The present invention is developed in view of the above background art, and an object is to provide a vibration power generation device which can easily adjust the resonance frequency in accordance with specific frequency of each apparatuses.

### MEANS FOR SOLVE THE PROBLEMS

In order to achieve above object, a vibration power generation device of the present invention comprising: a frame section; a weight section provided inside the frame section; a flexure section which is joined between the frame section and the weight section, said flexure section being configured to bend in response to a vibration of the weight section; and a power generation section composed of a laminate on one surface of the flexure section, said laminate having a lower electrode, a piezoelectric layer and an upper electrode which are laminated in this order from the bottom, said power generation section being configured to generate an alternating-current voltage in response to an oscillation of the weight section, wherein a resonance frequency adjustment means is provided between the frame section and the weight section.

In this vibration power generation device, it is preferable that the resonance frequency adjustment means is composed of a support beam section which is joined between the frame section and the weight section, said support beam section being provided separately from the flexure section, and that the resonance frequency is adjusted by the variation of initial shape of the support beam section.

In this vibration power generation device, it is preferable that, in the resonance frequency adjustment means, the support beam section is formed symmetrically as to a plane containing an aligned direction of the frame section, the flexure section and the weight section and a thickness direction of the flexure section and the weight section.

In this vibration power generation device, it is preferable that the support beam section has a plurality of folded portions between the frame section and the weight section so as to form a spring structure.

In this vibration power generation device, it is preferable that, in the spring structure, the folded portion has a curvature.

In this vibration power generation device, it is preferable that, in the resonance frequency adjustment means, the resonance frequency is adjusted at a predetermined value by the variation of the length of a piece of the support beam section.

In this vibration power generation device, it is preferable that, in the resonance frequency adjustment means, the resonance frequency is adjusted at a predetermined value by the variation of the width of a piece of the support beam section.

The frame section has a length. The frame section has a first support portion at one end in the longitudinal direction thereof, and has a second support portion at the other end in the longitudinal direction thereof. It is preferable that the flexure section is placed to the first support portion. It is preferable that the flexure section supports the weight section so that the weight section is located inside the frame section.

It is preferable that the resonance frequency adjustment means is composed of a support beam section. The support beam section is formed so as to join between the frame section and the weight section.

It is preferable that the weight section has a length. The weight section has a first end at one end in the longitudinal direction thereof, and has a second end at the other end in the longitudinal direction thereof. The first end of the weight section is joined to the first support portion through the flexure section. The support beam section joins between the frame section and the second end of the weight section.

It is preferable that the support beam section has a band piece and a joining piece. The band piece extends from the second end of the weight section toward the first support portion of the frame section. The band piece has a connecting portion. The connecting portion is located between the second end of the weight section and the first support portion of the frame section. Two band pieces are formed so as to join between the connecting portion and the frame section.

It is preferable that the joining piece is formed so as to join between the connecting portion and the second support portion of the frame section.

The weight section has a width. One end in the width direction of the weight section is defined as a width directional first end. The width directional first end is separated from the frame section by a clearance. It is preferable that the band piece and the joining piece are located in the clearance.

The band piece has a first end and a second end. The second end is located at opposite side to the first end when viewed from the band piece. It is preferable that the second end of the band piece is connected to the second end of the weight section. It is preferable that one end of the joining piece is connected to the first end of the band piece, and the other end of the joining piece is connected to the second support portion of the frame section.

The weight section has a width. One end in the width direction of the weight section is defined as a width directional first end, and the other end in the width direction of the weight section is defined as a width directional second end. It is preferable that the width directional first end is separated from the frame section by a first clearance. The width directional first end is separated from the frame section by a second clearance. The support beam section is composed of a plurality of support beam sections. One of the plurality of support beam sections is located in the first clearance, and another one of the plurality of support beam sections is located in the second clearance.

### ADVANTAGEOUS EFFECTS OF INVENTION

The vibration power generation device of the present invention includes the resonance frequency adjustment means between the frame section and the weight section. With this configuration, the present invention can form the vibration power generation device whose resonance frequency is adjusted at a predetermined value.

### BRIEF DESCRIPTION OF DRAWINGS

Fig. 1 shows a schematic exploded perspective view of a vibration power generation device according to an embodiment of the present invention;
Fig. 2 shows a schematic planar view of a substrate in the vibration power generation device according to the embodiment of the present invention;
Fig. 3 shows schematic planar views of modification examples of a support beam section in the vibration power generation device according to the embodiment of the present invention;
Fig. 4 shows a schematic exploded sectional view of the substrate in the vibration power generation device according to the embodiment of the present invention;
Fig. 5 shows sectional views taken along a line A-A' of Fig. 1 for explaining principal processes in a producing method of the substrate in the vibration power generation device according to the embodiment of the present invention; and
Fig. 6 shows a schematic sectional view of a conventional vibration power generation device.

### DESCRIPTION OF EMBODIMENTS

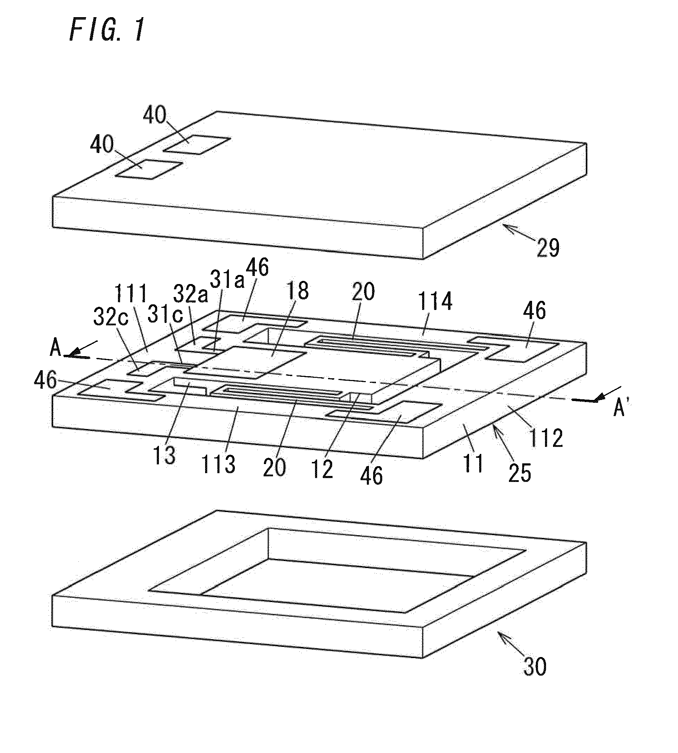

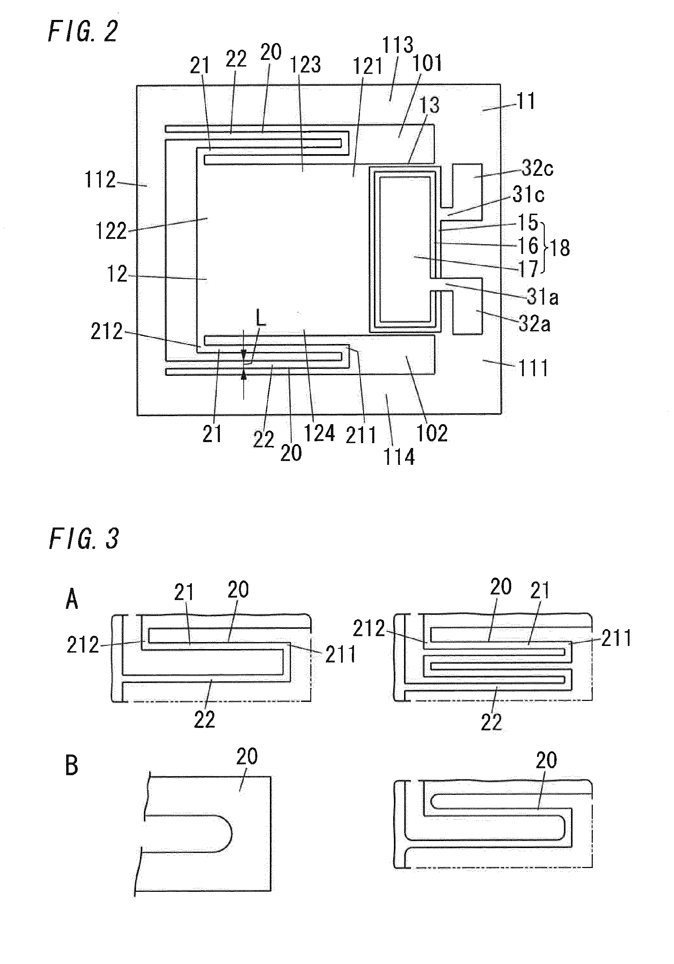

Figs. 1 to 4 show a vibration power generation device according to an embodiment of the present invention. This vibration power generation device includes a frame section **11,** a weight section **12,** a flexure section **13,** and a power generation section **18.** The weight section **12** is provided on the inside of the frame section **11.** The flexure section **13** is joined between the frame section **11** and the weight section **12,** and is configured to bend in response to a displacement of the weight section **12.** The power generation section **18** has a laminate formed on a one surface of the flexure section **13.** The laminate includes a lower electrode **15,** a piezoelectric layer **16** and an upper electrode **17** which are laminated in this order from the abovementioned one surface of the flexure section **13.** Thereby, the power generation section **18** is configured to generate an alternating-current voltage in response to an oscillation of the weight section **12.** A resonance frequency adjustment means is provided between the frame section **11** and the weight section **12.** The resonance frequency adjustment means is composed of a support beam section **20** which is joined between the frame section **11** and the weight section **12,** wherein the support beam section **20** is provided separately from the flexure section **13.** The resonance frequency is adjusted by the change of the shape of the support beam section **20.** In the resonance frequency adjustment means, the support beam section **20** is formed symmetrically as to a plane containing an aligned direction of the frame section **11,** the flexure section **13** and the weight section **12,** and a thickness direction of the flexure section **13** and the weight section **12.** The support beam section **20** is formed in a spring structure having a plurality of folded portions which are located between the frame section **11** and the weight section **12.** In the spring structure, the folded portion is formed with a curvature (R). In the resonance frequency adjustment means, the resonance frequency is adjusted at a predetermined value by the change of the length of the support beam section **20.** Further, in the resonance frequency adjustment means, the resonance frequency is adjusted at a predetermined value by the change of the width **("L"** shown in Fig. 2) of the support beam section **20.**

A substrate **25** of this vibration power generation device is formed of an SOI substrate. The SOI substrate has a support layer **26,** an insulation layer **27** and an active layer **28** in this order from the bottom. Each of the frame section **11** and the weight section **12** is mainly composed of the support layer **26,** the insulation layer **27** and the active layer **28.** Each of the flexure section **13** and the support beam section **20** is mainly composed of the insulation layer **27** and the active layer **28.**

In the vibration power generation device, as shown in Fig. 1, the power generation section **18** is provided at an active layer **28** side-surface of the substrate **25.** In the substrate **25,** when defining an active layer **28** side-surface as a "one surface", the substrate **25** is provided with a first cover substrate **29** at the abovementioned one surface. Herein, the first cover substrate **29** is fixed to the frame section **11.** In the substrate **25,** when defining a support layer **26** side-surface as a "the other surface", the substrate **25** is provided with a second cover substrate **30** at the abovementioned the other surface. Herein, the second cover substrate **30** is fixed to the frame section **11.** Each of the first cover substrate **29** and the second cover substrate **30** is formed of silicon, glass or the like. As described above, the vibration power generation device is formed of the substrate **25,** the first cover substrate **29** and the second cover substrate **30.**

Hereinafter, the vibration power generation device of the present embodiment is described in detail.

As shown in Fig. 2, outer shape in a planar view of the frame section **11** is a rectangular shape. Also, outer shapes in a planar view of the weight section **12** and the flexure section **13,** each of which is located on the inside of the frame section **11,** are rectangular shapes, respectively, as similar with the outer shape of the frame section **11.** Outer shape in a planar view of the power generation section **18,** which is formed at the abovementioned one surface side of the flexure section **13,** is a rectangular shape along the outer shape of the flexure section **13.** Note that, outer shape in a planar view of the support beam section **20** is not particularly limited, so long as it meets the conditions of joining between the frame section **11** and the weight section **12,** including a folded structure, and being able to control the oscillation of the weight section **12.** In the support beam section **20,** the length or the width **L** in initial shape of the support beam section **20** is determined according to a predetermined value of the resonance frequency. Note that, the initial shape in this specification means a shape of something when any external force (such as an inertial force due to acceleration) is not exerted to the vibration power generation device. The support beam section **20** is preferably connected to a tip side of the weight section **12** (comparatively larger vibrating side of the weight section **12)** in the initial shape. However, the configuration is not limited thereto. The support beam section **20** may be formed at the power generation section **18** side according to a desired value of the resonance frequency.

As shown in Fig. 2, the frame section **11** has a length and a width. The frame section **11** has a longitudinal direction along the length thereof. The frame section **11** has a width along a width direction intersecting with the longitudinal direction. The frame section **11** has a first support portion **111** and a second support portion **112.** The first support portion **111** is located at one end in the longitudinal direction of the frame section **11,** and the second support portion **112** is located at the other end in the longitudinal direction of the frame section **11.** The frame section **11** has a width directional first end **113** at one end in the width direction thereof, and has a width directional second end **114** at the other end in the width direction thereof.

The flexure section **13** is placed with respect to the first support portion **111.** In other words, the flexure section **13** is supported by the first support portion **111.** The flexure section **13** supports the weight section **12** so that the weight section **12** is located on the inside of the frame section **11.**

In detail, the weight section **12** has a length and a width. The length of the weight section **12** is formed along the longitudinal direction of the frame section **11.** The width of the weight section **12** is formed along a direction intersecting with the longitudinal direction of the frame section **11.** The weight section **12** has a first end **121** at one end in the longitudinal direction thereof, and has a second end **122** at the other end in the longitudinal direction thereof. The first end **121** of the weight section **12** is joined to the first support portion **111** through the flexure section **13.** The support beam section **20** is configured to join between the frame section **11** and the second end **122** of the weight section **12.**

The weight section **12** has a width directional first end **123** at one end in the width direction thereof, and has a width directional second end **124** at the other end in the width direction thereof. When viewed from the weight section **12,** the width directional first end **123** of the weight section **12** is located at the same side with the width directional first end **113** of the frame section **11.** When viewed from the weight section **12,** the width directional second end **124** of the weight section **12** is located at the same side with the width directional second end **114** of the frame section **11.** The width directional first end **123** of the weight section **12** is separated from the width directional first end **113** of the frame section **11** by a first clearance **101.** The width directional second end **124** of the weight section **12** is separated from the width directional second end **114** of the frame section **11** by a second clearance **102.**

The vibration power generation device includes the power generation section **18** on the abovementioned one surface of the flexure section **13.** The lower electrode **15,** the piezoelectric layer **16** and the upper electrode **17** are laminated in this order from the abovementioned one surface side of the flexure section **13,** in the power generation section **18.** Connecting wirings **31a, 31c,** each composed of a metal wiring, are formed on the abovementioned one surface side of the flexure section **13.** The connection wirings **31a, 31c** are connected to the lower electrode **15** and the upper electrode **17,** respectively. A lower electrode pad **32a** and an upper electrode pad **32c** electrically connected through the connection wirings **31a, 31c** are formed on the abovementioned one surface side of the flexure section **13.**

The power generation section **18** is designed so that the lower electrode **15** has the largest planar dimension, the piezoelectric layer **16** has a second largest planar dimension, and the upper electrode **17** has the smallest planar dimension. In the present embodiment, in a planar view, the piezoelectric layer **16** is located inside a peripheral line of the lower electrode **15,** and the upper electrode **17** is located inside a peripheral line of the piezoelectric layer **16.**

In the resonance frequency adjustment means of the present embodiment, the support beam section **20** includes symmetrically-located two support beam sections **20** at the abovementioned tip side of the weight section **12** in the initial shape. As shown in Fig. 3A, this support beam section **20** is formed in a spring structure having a plurality of folded portions. The number of the folded portions in the support beam section **20** is increased/decreased according to a predetermined value of the resonance frequency. In the spring structure, the resonance frequency is set at a desired value by changing the length of the support beam section **20** or the width of the support beam section **20.** Herein, when the weight section **12** vibrates, a stress may be concentrated to the folded portions. Therefore, in the folded structure, the folded portion is formed with a curvature (R) at the inner edge, as shown in Fig. 3B. Note that, the folded portion is preferably formed with a curvature (R) at the outer edge as similar with the inner edge.

As mentioned above, the support beam section **20** has the spring structure. In the following, the structure is explained from another view point. That is, the support beam section **20** has a band piece **21** and a joining piece **22.** As shown in Fig. 3A, the band piece **21** extends from the second end **122** of the weight section **12** toward the first support portion **111** of the frame section **11.** The band piece **21** has a connecting portion. The connecting portion is located between the second end **122** of the weight section **12** and the first support portion **111** of the frame section **11.**

In further detail, the band piece **21** has a first end **211** and a second end **212.** The second end **212** of the band piece **21** is located at opposite side to the first end **211** of the band piece **21.** The second end **212** of the band piece **21** is connected to the second end **122** of the weight section **12.**

The joining piece **22** is formed so as to join between the connecting portion and the frame section **11.** In detail, the joining piece **22** is formed so as to join between the connecting portion and the second support portion **112** of the frame section **11.** In further detail, one end of the joining piece **22** is connected to the first end **211** of the band piece **21,** and the other end of the joining piece **22** is connected to the second support portion **112** of the frame section **11.**

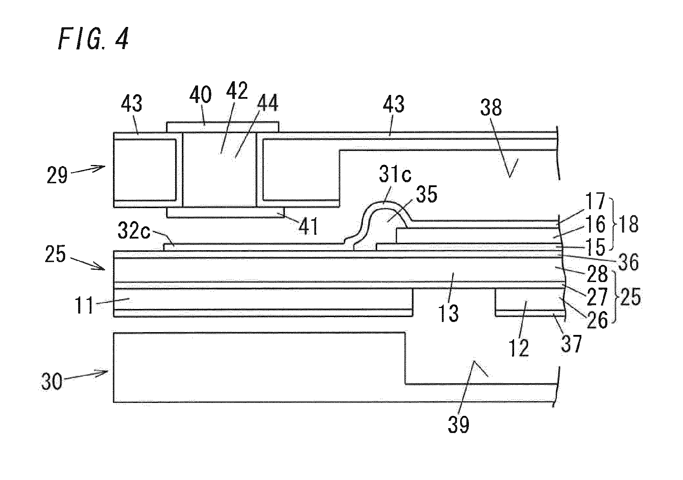

The joining piece **22** and the band piece **21** are located in a clearance between the width directional first end **123** and the frame section **11.** In detail, the joining piece **22** and the band piece **21** are arranged in the clearance **101** between the width directional first end **113** of the frame section **11** and the width directional first end **123,** and the joining piece **22** and the band piece **21** are arranged in the clearance **102** between the width directional second end **114** of the frame section **11** and the width directional second end **124.** As shown in Fig. 4, the power generation section **18** includes: the lower electrode **15** formed on the abovementioned one surface side of the flexure section **13;** the piezoelectric layer **16** formed on the lower electrode **15** at the opposite side to the flexure section **13;** and the upper electrode **17** formed on the piezoelectric layer **16** at the opposite side to the lower electrode **15.** The power generation section **18** is formed at least from a boundary between the flexure section **13** and the frame section **11** up to a boundary between the flexure section **13** and the weight section **12.** It is preferred that the peripheral line of the power generation section **18** is aligned with the boundary between the flexure section **13** and the frame section **11.** This configuration can improve the electric-generation capacity because non-contributory part for electric power generation by the vibration of the power generation section **18** does not exist. An insulation section **35** is formed on the abovementioned one surface side of the substrate **25** in order to prevent short-circuit between the lower electrode **15** and the connection wiring **31c** (herein, the connection wiring **31c** is electrically connected to the upper electrode 17). The insulation section **35** is formed so as to cover a frame section **11** side end of the lower electrode **15** and a frame section **11** side end of the piezoelectric layer **16.**

In this configuration, the insulation section **35** is formed of a silicon dioxide film, but is not limited to the silicon dioxide film. The insulation section **35** may be formed of a silicon nitride film. A seed layer of MgO layer (not shown in figure) is formed between the substrate **25** and the lower electrode **15.** Silicon dioxide films **36, 37** are formed on the abovementioned one surface side and the abovementioned the other surface side of the silicon substrate **25,** respectively.

When defining a substrate **25** side-surface of the first cover substrate **29** as a "one surface" of the first cover substrate **29,** the first cover substrate **29** is formed at the abovementioned one surface side thereof with a first recess **38** as a displacement space for a moving portion which is composed of the weight section **12** and the flexure section **13.**

The first cover substrate **29** is provided with output electrodes **40, 40** at a "the other surface" side of the first cover substrate **29.** The output electrode **40** is adapted to supply an alternating-current voltage generated in the power generation section **18** toward outside. Connection electrodes **41, 41** are formed on the abovementioned one surface side of the first cover substrate 29. Through-hole wirings **42, 42** are penetratingly provided through the first cover substrate **29** along the thickness direction. The output electrodes **40, 40** are electrically connected to the connection electrodes **41, 41** through the through-hole wirings **42, 42,** respectively. In the first cover substrate **29,** the connection electrodes **41, 41** are bonded to be electrically connected to the lower electrode pad **32a** and the upper electrode pad **32c** of the substrate **25,** respectively. In this configuration, each of the output electrodes **40, 40** and the connection electrodes **41, 41** is formed of a laminated film of a Ti film and an Au film. However, the materials and the layer structure are not particularly limited thereto. In this configuration, Cu is employed for the material of the through-hole wirings **42, 42,** but it is not limited thereto. For example, Ni, Al or the like can be employed.

In case of employing a silicon-based substrate as the first cover substrate **29** in the present embodiment, the first cover substrate **29** is provided with an insulation film **43** of a silicon dioxide film in order to prevent short-circuit between the two output electrodes **40, 40.** Herein, the insulation film **43** is formed across the abovementioned one surface side of the first cover substrate **29,** the abovementioned the other surface side of the first cover substrate **29,** and inner peripheral surfaces of through-holes **44, 44** inside which the through-hole wirings **42, 42** are formed. Note that, in case of employing an insulating substrate such as a glass-based substrate as the first cover substrate **29,** such an insulating film **43** can be omitted.

When defining a substrate **25** side-surface of the second cover substrate **30** as a "one surface" of the second cover substrate **30,** the second cover substrate **30** is formed at the abovementioned one surface side thereof with a second recess **39** as a displacement space for the moving portion composed of the weight section **12** and the flexure section **13.** Note that, the second cover substrate **30** is preferably formed of an insulating substrate such as a glass substrate.

The substrate **25** is provided with a first connection metal layer **46** for bonded to the first cover substrate **29** at the abovementioned one surface side of the substrate **25.** The first cover substrate **29** is provided with a second connection metal layer (not shown in figure) for bonded to the first connection metal layer **46.** The first connection metal layer **46** is formed of the same material with the lower electrode pad **32a** and the upper electrode pad **32c.** The first connection metal layer **46** is formed on the abovementioned one surface of the substrate **25** so as to have the same thickness with the lower electrode pad **32a** and the upper electrode pad **32c.**

In this configuration, the substrate **25,** the first cover substrate **29,** and the second cover substrate **30** are bonded through a room-temperature bonding method, but the bonding method is not limited to the room-temperature bonding method. For example, they may be bonded through an anodic bonding method or a resin bonding method using an epoxy resin etc. Note that, the vibration power generation device of the present embodiment is produced using manufacturing technique of MEMS device and the like.

In the above described vibration power generation device of the present embodiment, the power generation section **18** is composed of the lower electrode **15,** the piezoelectric layer **16,** and the upper electrode **17.** In this configuration, when the flexure section **13** vibrates, the piezoelectric layer **16** is subjected to a stress. Then, it generates a deviation in electric charge in the lower electrode **15** and the upper electrode **17.** Thereby, an alternating-current voltage generates in the power generation section **18.** At this time, the support beam section **20** restricts an excess vibration of the weight section **12.**

In this instance, a power generation efficiency increases with an increase of a power generation index **P** which meets a relation of **Pα e312/ε,** where **ε is** a relative permittivity of a piezoelectric material used for the piezoelectric layer **16** of the vibration power generation device. In consideration of general values of a piezoelectric constant **e31** and a relative permittivity **ε** of each of PZT and AIN which are typical piezoelectric materials used for the vibration power generation device, the power generation index P can be more increased by employing PZT, because PZT has a larger piezoelectric constant **e31** which contributes to the power generation index **P** at a square. In the vibration power generation device of the present embodiment, PZT which is a kind of lead-based piezoelectric material is used for the piezoelectric material of the piezoelectric layer **16.** However, the lead-based piezoelectric material is not limited to PZT. For example, PZT-PMN (:Pb(Mn,Nb)O₃) or PZT dope with other impurities may be employed. Note that, the piezoelectric material of the piezoelectric layer **16** is not limited to the lead-based piezoelectric material, and other piezoelectric material may be employed.

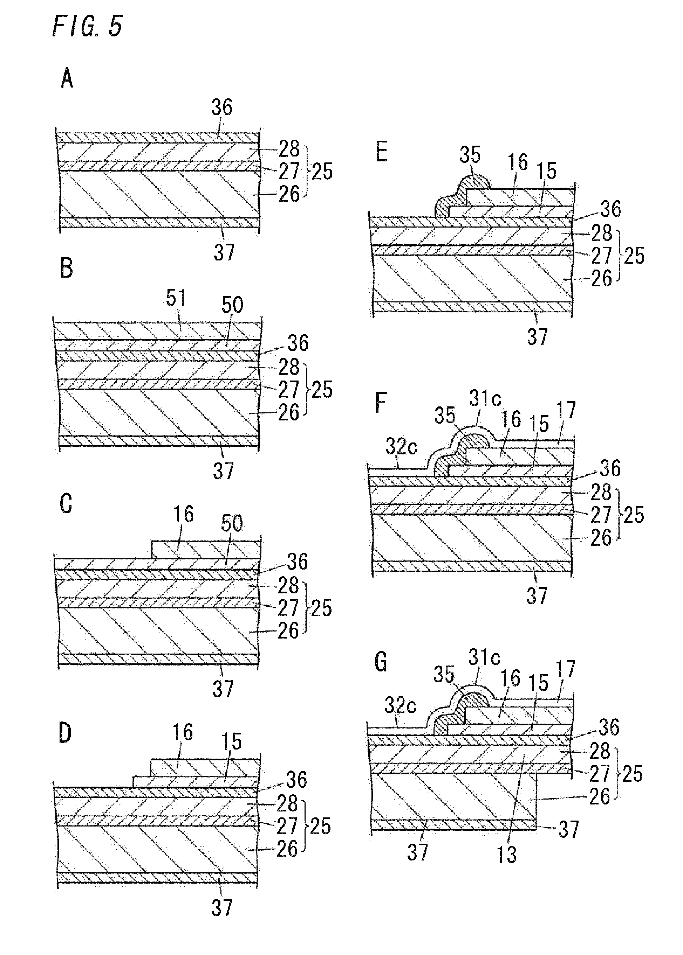

Hereinafter, a producing method of the vibration power generation device of the present embodiment is described with reference to Fig. 5. Figs. 5A to 5G show the region corresponding to a cross-section taken along line A-A' in Fig. 1.

Firstly, an insulating film forming process is performed. In the insulating film forming process, silicon dioxide films **36, 37** are formed on one surface side and the other surface side of a silicon substrate **25** formed of silicon, respectively, through a thermal oxidation method or the like. Thereby, a structure shown in Fig. 5A is obtained.

Then, a metal layer forming process is performed. In the metal layer forming process, a metal layer **50** of a Pt layer is formed on the whole of the abovementioned one surface of the substrate **25** by a sputtering method, a CVD method or the like. Herein, the metal layer **50** becomes the basis of a lower electrode **15,** a connection wiring **31a** and a lower electrode pad **32a.** Subsequently, a piezoelectric film forming process is performed. In the piezoelectric film forming process, a piezoelectric film **51** (such as a PZT film) of a piezoelectric material (such as PZT) is formed on the whole of the abovementioned one surface of the substrate **25** by a sputtering method, a CVD method, a sol-gel method or the like. Herein, the piezoelectric film **51** becomes the basis of a piezoelectric layer **16.** Thereby, a structure shown in Fig. 5B is obtained. Note that, the metal layer **50** is not limited to the Pt layer. For example, the metal layer **50** may be an Al layer or an Al-Si layer. Also, the metal layer **50** may be a combination of a Pt layer and a Ti layer interposed between the Pt layer and a seed layer. Herein, the Ti layer serves for improving the adhesion property. The material of the adhesion layer is not limited to Ti. The material may be Cr, Nb, Zr, TiN, TaN or the like.

After the piezoelectric film forming process, a piezoelectric film patterning process is performed. In the piezoelectric film patterning process, the piezoelectric film **51** is patterned through a photolithography technique and an etching technique to form the piezoelectric layer **16** formed of a part of the piezoelectric film **51.** Thereby, a structure shown in Fig. 5C is obtained.

After then, a metal layer patterning process is performed. In the metal layer patterning process, the metal layer **50** is patterned through a photolithography technique and an etching technique to form the lower electrode **15,** the connection wiring **31a** and the lower electrode pad **32a** each of which is formed of a part of the metal layer **50.** Thereby, a structure shown in Fig. 5D is obtained. In the metal layer patterning process of the present embodiment, the connection wiring **31** a and the lower electrode pad **32a** are formed simultaneously with forming the lower electrode **15** by patterning the metal layer **50.** However, forming method of these components is not limited thereto. For example, a wiring forming process for forming the connection wiring **31a** and the lower electrode pad **32a** may be separately performed, after only forming the lower electrode **15** by patterning the metal layer **50** in a metal layer patterning process. Furthermore, a connection wiring forming process for forming the connection wiring **31a** and a lower electrode pad forming process for forming the lower electrode pad **32a** may be performed separately. Note that, the metal layer **50** may be etched by an RIE method, an ion milling method or the like.

After forming the lower electrode **15,** the connection wiring **31a** and the lower electrode pad **32a** through the metal layer patterning process, an insulation section forming process is performed. In the insulation section forming process, an insulation section **35** is formed on the abovementioned one surface side of the substrate **25.** Thereby, a structure shown in Fig. 5E is obtained. In the insulation section forming process, an insulation layer is formed on the whole of the abovementioned one surface side of the substrate **25** by a CVD method or the like, and then the insulation layer is patterned through a photolithography technique and an etching technique. However, this process is not limited thereto. For example, the insulation section **35** may be formed through a liftoff process.

After the insulation section forming process, an upper electrode forming process and a wiring forming process are simultaneously performed. In the upper electrode forming process, an upper electrode **17** is formed through a thin-film forming technique of an EB evaporation method, a sputtering method, a CVD method or the like, a photolithography technique and an etching technique. In the wiring forming process, a connection wiring **31c** and an upper electrode pad **32c** are formed through a thin-film forming technique of an EB evaporation method, a sputtering method, a CVD method or the like, a photolithography technique and an etching technique. Thereby, a structure shown in Fig. 5F is obtained. That is, in the present embodiment, the connection wiring **31 c** and the upper electrode pad **32c** are formed together with the formation of the upper electrode **17** in an upper electrode forming process. However, forming method of these components is not limited thereto. The upper electrode forming process and the wiring forming process may be performed separately. As to the wiring forming process, a connection wiring forming process for forming the connection wiring **31c** and an upper electrode pad forming process for forming the upper electrode pad **32c** may be performed separately. The upper electrode **17** is preferably etched by dry etching such as an RIE method, but wet etching may be applied. For example, an Au film may be wet-etched by a potassium iodide solution, and a Ti film may be wet-etched by a hydrogen peroxide solution. Herein, the upper electrode **17** is formed of Pt, Al, Al-Si or the like.

After forming the upper electrode **17,** the connection wiring **31c** and the upper electrode pad **32c,** a substrate treatment process is performed. In the substrate treatment process, a frame section **11,** a weight section **12,** a flexure section **13** and a support beam section **20** are formed through a photolithography technique, an etching technique and the like. Thereby, a structure shown in Fig. 5G is obtained. In the substrate treatment process in the present embodiment, a front side groove forming process, a back side groove forming process and an etching process are performed in this order. In the front side groove forming process, a front side groove is formed by etching the substrate **25** up to reaching an insulation layer **27** from the abovementioned one surface side so as to remove a part except the frame section **11,** the weight section **12,** the flexure section **13** and the support beam section **20** through a photolithography technique, an etching technique and the like. In the back side groove forming process, a back side groove is formed by etching the substrate **25** up to reaching the insulation layer **27** from the abovementioned the other surface side to remove a part except the frame section **11** and the weight section **12** through a photolithography technique, an etching technique and the like. In the etching process, the front side groove and the back side groove are communicated by etching the insulation layer **27,** so that the frame section **11,** the weight section **12,** the flexure section **13,** and the support beam section **20** are formed. As a result, a power generation device shown in Fig. 5G is obtained.

In the front side groove forming process and the back side groove forming process in the substrate treatment process according to the present embodiment, the substrate **25** is etched through an inductively-coupled plasma (ICP) type etching equipment capable of vertical deep etching. Therefore, an angle between the back side of the flexure section **13** and an inner surface of the frame section **11** can be made about 90 degree. Note that, the front side groove forming process and the back side groove forming process in the substrate treatment process are not limited to dry etching through the ICP type dry-etching equipment. Another dry-etching equipment can be used, so long as it can perform a high anisotropic etching. In case that the abovementioned one surface of the substrate **25** is a (110) surface, wet etching (crystal anisotropic etching) using an alkaline solution such as a TMAH solution or a KOH solution may be used.

For obtaining the power generation device of the present embodiment, processes until finishing the substrate treatment process are performed in a wafer. After then, a dicing process is performed, thereby the units formed in the wafer is divided into an individual vibration power generation device.

Note that, the present embodiment includes a first cover substrate **29** and a second cover substrate **30.** Therefore, after performing the abovementioned etching process in which the flexure section **13** is formed, a cover bonding process is performed. In the cover bonding process, the cover substrates **29, 30** are bonded. In this case, processes until finishing the cover bonding process are performed in the wafer, and a dicing process is further performed thereby the wafer is divided into an individual power generation device. Each of the cover substrates **29, 30** is preferably formed by arbitrarily employing a known process such as a photolithography process, an etching process, a thin-film forming process, a plating process and the like.

In the power generation section **18,** the piezoelectric layer **16** is formed on the lower electrode **15.** In this instance, the crystallinity of the piezoelectric layer **16** can be further improved by providing a buffer layer (not shown), which serves as a foundation when forming the piezoelectric layer **16,** between the lower electrode **15** and the piezoelectric layer **16.** A kind of conductive oxide material such as SrRuO₃, (Pb,Ra)TiO₃, PbTiO₃ or the like may be employed as a material of the buffer layer.

As described above, the vibration power generation device of the present embodiment includes the resonance frequency adjustment means provided between the frame section **11** and the weight section **12.** With this configuration, it is possible to form such a vibration power generation device in which the resonance frequency in the initial shape is adjusted at a predetermined value.

In the vibration power generation device of the present embodiment, the resonance frequency adjustment means is composed of the support beam section **20** which is joined between the frame section **11** and the weight section **12** and which is provided separately from the flexure section **13,** and the resonance frequency is adjusted by changing the shape of the support beam section **20.** With this configuration, it is possible to form such a vibration power generation device in which the resonance frequency in the initial shape is adjusted at a predetermined value. In addition, this configuration can suppress a possibility of damaging the vibration power generation device caused by a sudden increase of displacement of the weight section **12** due to an application of an excess acceleration to the vibration power generation device.

In the vibration power generation device of the present embodiment, in the resonance frequency adjustment means, the support beam section **20** is formed symmetrically in the plane which containing the aligned direction of the frame section **11,** the flexure section **13** and the weight section **12,** and the thickness direction of the flexure section and the weight section. That is, the support beam section **20** is formed in a symmetrical supporting condition in the initial shape. With this configuration, the vibration property of the vibration power generation device is hardly affected, thereby this configuration can improve the stability of vibration state.

In the vibration power generation device of the present embodiment, the support beam section **20** has the spring structure having a plurality of the folded portions located between the frame section **11** and the weight section **12.** This configuration makes it possible to restrict the amplitude of the weight section **12,** wherein the weight section **12** is vibrated due to an acceleration applied to the vibration power generation device, thereby can suppress a possibility of damaging the vibration power generation device. In addition, the vibration power generation device can be formed to have a predetermined adjusted value of the resonance frequency in the initial shape by adjusting the number of the folded portions.

In the vibration power generation device of the present embodiment, the folded portion in the spring structure is formed with a curvature (R). With this configuration, the support beam section **20** can alleviate the concentration of stress, and can improve the acceleration resistant property.

In the vibration power generation device of the present embodiment, in the resonance frequency adjustment means, the resonance frequency is adjusted at a predetermined value by the change of the length of a side of the support beam section **20.** With this configuration, the vibration power generation device can easily change the resonance frequency only by changing the length in the initial shape of the support beam section **20.**

In the vibration power generation device of the present embodiment, in the resonance frequency adjustment means, the resonance frequency is adjusted at a predetermined value by the change of the width of a side of the support beam section **20.** With this configuration, the vibration power generation device can easily change the resonance frequency only by changing the width in the initial shape of the support beam section **20.**

Because including the support beam section **20,** the vibration power generation device can suppress a possibility of damaging the flexure section **13** due to applying an excess load to the weak flexure section **13** during such as a dip process in wet-etching or removal of resist. Thereby, the support beam section **20** can suppress a possibility of damaging the flexure section **13.** In addition, it can prevent the thinly formed flexure section **13** from distorting due only to an influence of a residual stress in the piezoelectric layer **16** of the power generation section **18** or an influence of a gravity of the weight section **12.**

Besides, the frame section **11** has the length. The frame section **11** has the first support portion **111** at one end in the longitudinal direction, and has the second support portion **112** at the other end in the longitudinal direction. The flexure section **13** is supported by the first support portion **111.** The flexure section **13** supports the weight section **12** so that the weight section **12** is located on the inside of the frame section **11.**

The weight section **12** has the length. The weight section **12** has the first end **121** at one end in the longitudinal direction thereof, and has the second end **122** at the other end in the longitudinal direction thereof. The first end **121** of the weight section **12** is joined to the first support portion **111** through the flexure section **13.** The support beam section **20** joins between the frame section **11** and the second end **122** of the weight section **12.**

The support beam section **20** has the band piece **21** and the joining piece **22.** The band piece **21** extends from the second end **122** of the weight section **12** toward the first support portion **111** of the frame section **11.** The band piece **21** has the connecting portion. The connecting portion is located between the second end **122** of the weight section **12** and the first support portion **111** of the frame section **11.** The joining piece **22** is formed so as to join between the connecting portion and the frame section **11.** When acceleration is applied to the vibration power generation device, the weight section **12** is vibrated. With this configuration, the amplitude of vibration of the weight section **12** caused by the acceleration can be restricted. In detail, the vibration, along with the thickness direction of the frame **11,** of the weight section **12** caused by an acceleration applied to the vibration power generation device can be restricted. That is, the amplitude of the weight section **12** along the thickness direction of the frame section **11** is restricted. As a result, this configuration can suppress a possibility of damaging the vibration power generation device.

Furthermore, the joining piece **22** is formed so as to join between the connecting portion and the second support portion **112** of the frame section **11.** With this configuration, the amplitude of vibration of the weight section **12** caused by an acceleration applied to the vibration power generation device can be restricted. In detail, the vibration, along with the thickness direction of the frame **11,** of the weight section **12** caused by an acceleration applied to the vibration power generation device can be restricted. That is, the amplitude of the weight section **12** along the thickness direction of the frame section **11** is restricted. As a result, this configuration can suppress a possibility of damaging the vibration power generation device.

The weight section **12** has the width. One end of the weight section **12** in the width direction is defined as the width directional first end **123.** The width directional first end **123** is separated from the frame section **11** by the first clearance **101.** The support beam section 20 is arranged in the first clearance **101.** With this configuration, the support beam section 20 prevents the weight section **12** from vibrating in a direction along with the width direction of the weight section **12.** As a result, this configuration can reduce such a force applied to the flexure section **13** along with the width direction of the weight section **12.** Therefore, this configuration makes it possible to prevent the flexure section **13** from damaged.

The band piece **21** has the first end **211** and the second end **212.** The second end **212** of the band piece **21** is located at opposite side to the first end **211** of the band piece **21.** The second end **212** of the band piece **21** is connected to the second end **122** of the weight section **12.** One end of the joining piece **22** is connected to the first end **211** of the band piece **21,** and the other end of the joining piece **22** is connected to the second support portion **112** of the frame section **11.** Therefore, the amplitude of the weight section **12** along the thickness direction of the frame section **11** is restricted. As a result, this configuration can suppress a possibility of damaging the vibration power generation device.

The support beam section **20** arranged in the first clearance **101** and the support beam section **20** arranged in the second clearance **102** are formed symmetrically with respect to the weight section **12.** Therefore, the amplitude of the weight section **12** along the thickness direction of the frame section **11** is restricted. As a result, this configuration can suppress a possibility of damaging the vibration power generation device.

The frame section **11** has the width directional first end **113** at one end in the width direction, and has the width directional second end **114** at the other end in the width direction. The weight section **12** has the width directional first end **123** at one end in the width direction, and has the width directional second end **124** at the other end in the width direction. When viewed from the weight section **12,** the width directional first end **113** of the frame section **11** is located at the same side with the width directional first end **123** of the weight section **12.** When viewed from the weight section **12,** the width directional second end **114** of the frame section **11** is located at the same side with the width directional second end **124** of the weight section **12.** The width directional first end **123** of the weight section **12** is separated from the width directional first end **113** of the frame section **11** by the first clearance **101.** The width directional second end **124** of the weight section **12** is separated from the width directional second end **114** of the frame section **11** by the second clearance **102.** The support beam section **20** is composed of a plurality of support beam sections **20.** One of the plurality of support beam sections **20** is arranged in the first clearance **101,** and another one of the plurality of support beam sections **20** is arranged in the second clearance **102.** Therefore, the amplitude of the weight section **12** along the thickness direction of the frame section **11** is restricted. As a result, this configuration can suppress a possibility of damaging the vibration power generation device.

In the present embodiment, the vibration power generation device has two of the support beam sections **20.** However, the number of the support beam sections **20** is not limited thereto. For example, the number may be one or more than three. That is, the number of the support beam section **20** may be one or more.

### REFERENCE SIGNS LIST

- 11: frame section
- 12: weight section
- 13: flexure section
- 15: lower electrode
- 16: piezoelectric layer
- 17: upper electrode
- 18: power generation section
- 20: support beam section
- 25: substrate
- 29: first cover substrate
- 30: second cover substrate
- 31 a, 31 c: connection wiring
- 32a: lower electrode pad
- 32c: upper electrode pad
- 40: output electrode
- 46: first connection metal layer

## Claims

1. A vibration power generation device comprising:
a frame section;
a weight section provided on the inside of said frame section;
a flexure section which is joined between said frame section and said weight section, said flexure section being configured to bend in response to a vibration of said weight section; and
a power generation section composed of a laminate on one surface of said flexure section, said laminate having a lower electrode, a piezoelectric layer and an upper electrode which are laminated in this order from said one surface, said power generation section being configured to generate an alternating-current voltage in response to an oscillation of said weight section,
wherein a resonance frequency adjustment means is provided between said frame section and said weight section.

2. The vibration power generation device as set forth in claim 1, wherein
said resonance frequency adjustment means is composed of a support beam section which is joined between said frame section and said weight section, said support beam section being provided separately from said flexure section, and
the resonance frequency is adjusted by the change of initial shape of said support beam section.

3. The vibration power generation device as set forth in claim 2, wherein, in said resonance frequency adjustment means, said support beam section is formed symmetrically as to a plane containing an aligned direction of said frame section, said flexure section and said weight section and a thickness direction of said flexure section and said weight section.

4. The vibration power generation device as set forth in claim 2 or 3, wherein said support beam section is formed in a spring structure having a plurality of folded portions located between said frame section and said weight section.

5. The vibration power generation device as set forth in claim 4, wherein, in said spring structure, said folded portion is formed with a curvature.

6. The vibration power generation device as set forth in any one claims of 2 to 5, wherein, in said resonance frequency adjustment means, the resonance frequency is adjusted at a predetermined value by the change of the length of said support beam section.

7. The vibration power generation device as set forth in any one claims of 2 to 5, wherein, in said resonance frequency adjustment means, the resonance frequency is adjusted at a predetermined value by the change of the width of said support beam section.

8. The vibration power generation device as set forth in claim 1, wherein
said frame section has a length,
said frame section has a first support portion at one end in the longitudinal direction, and has a second support portion at the other end in the longitudinal direction,
said flexure section is supported by said first support portion, and
said flexure section supports said weight section so that said weight section is located on the inside of said frame section.

9. The vibration power generation device as set forth in claim 8, wherein
said resonance frequency adjustment means is composed of a support beam section, and
said support beam section is formed to join between said frame section and said weight section.

10. The vibration power generation device as set forth in claim 9, wherein
said weight section has a length,
said weight section has a first end at one end in the longitudinal direction, and has a second end at the other end in the longitudinal direction,
said first end of said weight section is joined to said first support portion through said flexure section, and
said support beam section joins between said frame section and said second end of said weight section.

11. The vibration power generation device as set forth in claim 10, wherein
said support beam section has a band piece and a joining piece,
said band piece extends from said second end of said weight section toward said first support portion of said frame section,
said band piece has a connecting portion, said connecting portion being located between said second end of said weight section and said first support portion of said frame section, and
said joining piece is formed to join between said connecting portion and said frame section.

12. The vibration power generation device as set forth in claim 11, wherein said joining piece is formed to join between said connecting portion and said second support portion of said frame section.

13. The vibration power generation device as set forth in claim 12, wherein
said weight section has a width,
one end in the width direction of said weight section is defined as a width directional first end,
said width directional first end is separated from said frame section by a first clearance, and
said support beam section is arranged in said first clearance.

14. The vibration power generation device as set forth in claim 12, wherein
said weight section has a width,
one end in the width direction of said weight section is defined as a width directional first end, and the other end in the width direction of said weight section is defined as a width directional second end,
said width directional first end is separated from said frame section by a first clearance,
said width directional first end is separated from said frame section by a second clearance,
said support beam section has a plurality of support beam sections, and
one of said plurality of support beam sections is arranged in said first clearance, and another one of said plurality of support beam sections is arranged in said second clearance.

15. The vibration power generation device as set forth in claim 13 or 14, wherein
said band piece has a first end and a second end, said second end being located at opposite side to said first end,
said second end of said band piece is connected to said second end of said weight section,
one end of said joining piece is connected to said first end of said band piece, and the other end of said joining piece is connected to said second support portion of said frame section.

16. The vibration power generation device as set forth in claim 15, wherein said support beam section arranged in said first clearance and said support beam section arranged in said second clearance are formed symmetrically with respect to said weight section.
